# EUROPEAN PATENT SPECIFICATION

(11) **EP 0 735 671 B1**
(45) Date of publication and mention of the grant of the patent: **06.06.2001**
(21) Application number: 96104993.9
(22) Date of filing: 28.03.1996
(51) Int. Cl.: H03H 9/05

(54) **Surface acoustic wave devices**
Akustische Oberflächenwellenanordnungen
Dispositifs à ondes acoustiques de surface

(30) Priority: 28.03.1995 JP 6982695
(43) Date of publication of application: 02.10.1996
(73) Proprietor: MATSUSHITA ELECTRIC INDUSTRIAL CO., LTD., Kadoma-shi, Osaka 571-0050 (JP)
(72) Inventor: Tsuji, Yasunobu, Uji-shi, Kyoto, 611 (JP); Taguchi, Yutaka, Takatsuki-shi, Osaka, 569 (JP); Onishi, Keiji, Settsu-shi, Osaka, 566 (JP); Eda, Kazuo, Nara-shi, Nara, 631 (JP); Miyauchi, Katsuyuki, Torikainishi, Settsu-shi, Osaka, 566 (JP)
(74) Representative: Grünecker, Kinkeldey, Stockmair & Schwanhäusser Anwaltssozietät

(56) References cited:
- EP-A- 0 637 871
- PATENT ABSTRACTS OF JAPAN vol. 016, no. 255 (E-1214), 10 June 1992 & JP-A-04 056510 (CLARION CO LTD), 24 February 1992,

## Description

### II. Background of the Invention

### Field of the Invention

The present invention relates to a surface acoustic wave device, and more particularly to a packing structure of surface acoustic wave device mounting surface acoustic wave elements by face-down method.

### Description of the Prior Art

Along with the advancement of mobile communication technology, the demand is becoming stricter for electric characteristics and downsizing of surface acoustic wave devices used as interstage filters and antenna filters for transmission and reception in various mobile communication apparatuses.

As an effective method for downsizing the surface acoustic wave devices, the face-down mounting method is known. In the face-down mounting method, the functional surface of elements and circuit board are set face to face, and both are connected electrically and mechanically by conductive bumps or the like, and bonding wire is not necessary, which is a major feature thereof (see for example prior art EP-A 0 637 871).

However, since surface acoustic waves propagate on the functional surface of the surface acoustic wave element, it requires a space not blocking propagation of surface elastic waves near the functional surface. Besides. the piezoelectric substrate used in surface acoustic wave elements is generally high in pyroelectricity, and therefore when the operating frequency becomes high, the line width of the comb-shaped electrode of the surface acoustic waves becomes about 0.5*µ*m to about 1*µ*m, and hence the comb-shaped electrode may be broken due to temperature changes in the process such as forming of conductive bump and pyroelectricity of the piezoelectric substrate. It was therefore necessary to consider the intrinsic problem of surface acoustic wave elements.

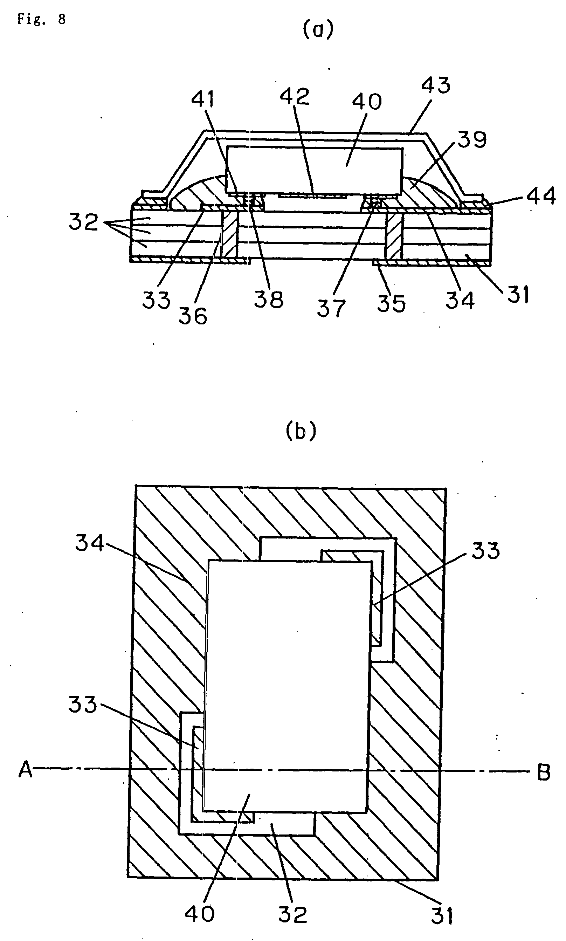

Fig. 8(a) is a sectional view of a surface acoustic wave device in a conventional example, and Fig. 8 (b) shows its top view.

In the diagram, reference numeral 31 is a multi-layer substrate, 32 is a dielectric layer, 33 shows input and output electrodes, 34 is a grounding electrode, 35 is an outer electrode, 36 is a via hole, 37 is a metal bump, 38 is a conductive resin, 39 is an insulating resin, 40 is a surface acoustic wave element, 41 is an electrode pad, 42 is a comb-shaped electrode, 43 is a metal cap, and 44 is solder.

The surface acoustic wave device thus constituted is described below. In the surface acoustic wave element 40, the electrode pad 41 and comb-shaped electrode 42 are formed. The metal bump 37 made of gold or aluminum is formed on the electrode pad 41, and the conductive resin 38 is transferred and applied on its tip. The surface acoustic wave element 40, and the multi-layer substrate 31 forming the input and output electrodes 33 and grounding electrode 34 at the principal surface side of the dielectric layer 32 are set face to face, and are positioned, and then the surface acoustic wave element 40 is mounted. By heating and curing the conductive resin 38, the surface acoustic wave element 40 is affixed to the multi-layer substrate 31, thereby connecting electrically and mechanically. Furthermore, around the surface acoustic wave element 40, the insulating resin 39 adjusted to a high viscosity was injected, heated and cured, and the adhesive strength of the surface acoustic wave element 40 and the multi-layer substrate 31 was reinforced. Moreover, the input and output electrodes 33 and grounding electrode 34 were electrically connected with the outer electrode 35 through the via hole 36, and the metal cap 43 was adhered with the grounding electrode 34 with solder 44, thereby sealing airtight. By this method, it is possible to hold a space around the comb-shaped electrode 42 of the surface acoustic wave element 40, and problems such as breakage of the comb-shaped electrode 42 of the surface acoustic wave element 40 in the process were solved.

However, in this constitution, since the multi-layer substrate 31 was flat, the insulating resin 39 spread widely. Therefore, to seal airtight with the metal cap 43, it was necessary to widen the interval between the metal cap 43 and surface acoustic wave element 40, and it was hard to reduce the size.

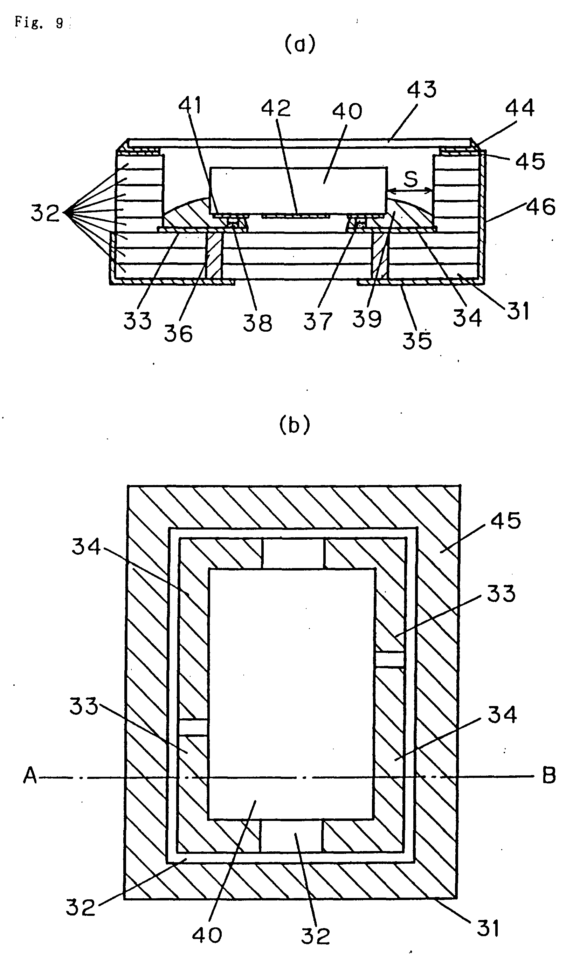

To solve this problem, Fig. 9 (a) shows a sectional view of surface acoustic wave device in other prior art, and Fig. 9 (b) shows its top view.

In the diagram, reference numeral 45 denotes a grounding electrode, 46 is an outer terminal, and others same as in Fig. 8 (a) and (b) are identified with same reference numerals.

In the surface acoustic wave device thus constituted, the grounding electrode 45 is electrically connected to the outer electrode 35 through the outer terminal 46, and the multi-layer substrate 31 is changed from the flat type to a recess type taller in height than the surface acoustic wave element 40, and others are same as in the constitution in Fig. 8.

In such constitution, since the multi-layer substrate 31 is of recess type, spreading of the insulating resin 39 can be prevented, but the space must be held around the comb-shaped electrode 42 of the surface acoustic wave element 40, and therefore the viscosity of the insulating resin 39 must be heightened. In such a case, when the gap S between the surface acoustic wave element 40 and the multi-layer substrate 31 is narrow, since the multi-layer substrate 31 is of recess type taller than the surface acoustic wave element 40, it is hard to inject insulating resin 39, and the insulating resin 39 does not permeate up to the periphery of the metal bump 37, and the adhesive strength cannot be reinforced. Accordingly, to permeate the insulating resin 39 nearly to the periphery of the metal bump 37, it is required to widen the gap S between the surface acoustic wave element 40 and the multi-layer substrate 31, and, as a result, it was hard to reduce the size.

### III. Summary of the Invention

It is hence an object of the invention to present a surface acoustic wave device capable of reducing the size, while preventing the insulating resin from spreading.

To achieve the object, the surface acoustic wave device of the invention comprises a multi-layer substrate possessing input and output electrodes and grounding electrode on the mounting surface side of a dielectric layer, and possessing an outer electrode on the other surface of said dielectric layer, with said input and output electrodes and grounding electrode connected electrically with the outer electrode respectively, a surface acoustic wave element mounting a principal surface forming an electrode pad and comb-shaped electrode by face-down method, a metal bump applying a conductive resin on said electrode pad, and an insulating resin formed on the periphery of the metal bump, wherein said input and output electrodes, grounding electrode and surface acoustic wave element are electrically connected through the metal bump respectively, and a guard layer shorter in height than the surface acoustic wave element is formed outside of the surface acoustic wave element, on the mounting surface side of said multi-layer substrate.

In such constitution, spreading of the insulating resin can be prevented, and since the guard layer is shorter in height than the surface acoustic wave element, it is easier to inject the insulating resin, and therefore if the gap of the surface acoustic wave element and the multi-layer substrate is narrow, the insulating resin permeates closely to the metal bump, so that the surface acoustic wave element may be reduced in size.

### IV. Brief Description of the Drawings

Fig. 1 (a) is a sectional view of a surface acoustic wave device in a first embodiment of the invention, and (b) is its top view;
Fig. 2 (a) is a sectional view of a surface acoustic wave device in a second embodiment of the invention, and (b) is its top view;
Fig. 3 (a) is a sectional view of a surface acoustic wave device in a third embodiment of the invention, (b) is its top view, and (c) is a top view of the functional surface of a surface acoustic wave element of the device;
Fig. 4 (a) is a sectional view of a surface acoustic wave device in a fourth embodiment of the invention, (b) is its top view, and (c) is a top view of the functional surface of a surface acoustic wave element of the device;
Fig. 5 (a) is a sectional view of a surface acoustic wave device in a fifth embodiment of the invention, (b) is its top view, and (c) is a top view of the functional surface of a surface acoustic wave element of the device;
Fig. 6 (a) is a sectional view of a surface acoustic wave device in a sixth embodiment of the invention, and (b) is its top view;
Fig. 7 (a) is a sectional view of a surface acoustic wave device in a seventh embodiment of the invention, and (b) is its top view;
Fig. 8 (a) is a sectional view of a surface acoustic wave device in a prior art, and (b) is its top view; and
Fig. 9 (a) is a sectional view of a surface acoustic wave device in other prior art, and (b) is its top view.

### V. Detailed Description of the Invention

### (Embodiment 1)

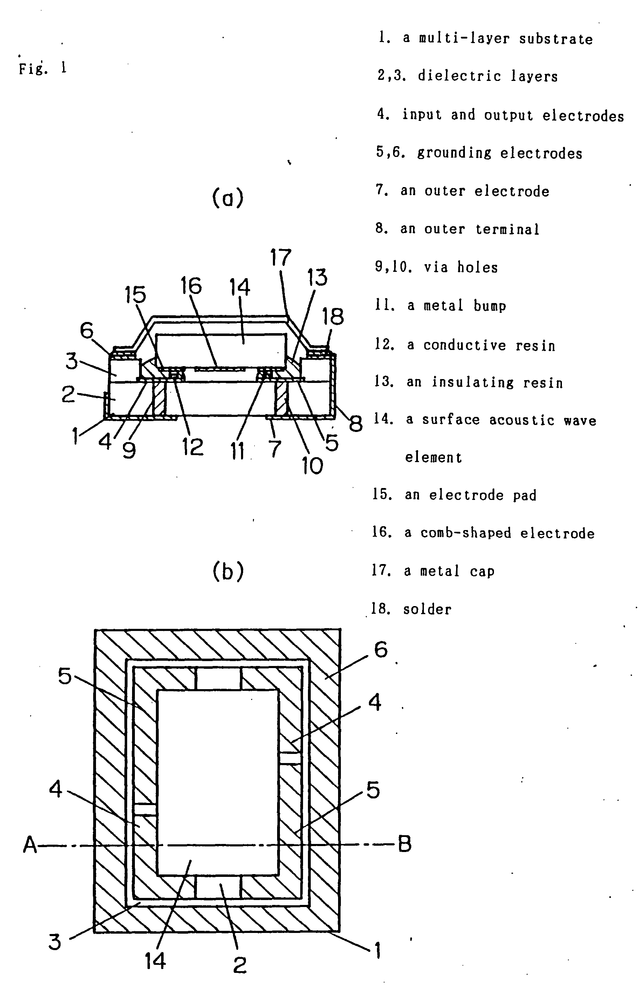

Referring now to the drawing, the first embodiment of the invention is described in detail below. Fig. 1 (a) is a sectional view of a surface acoustic wave device in the first embodiment of the invention, and Fig. 1 (b) is its top view.

In the diagram, reference numeral 1 is a multi-layer substrate, 2, 3 are dielectric layers, 4 shows input and output electrodes, 5, 6 are grounding electrodes, 7 is an outer electrode, 8 is an outer terminal, 9, 10 are via holes, 11 is a metal bump, 12 is a conductive resin, 13 is an insulating resin, 14 is a surface acoustic wave element, 15 is an electrode pad, 16 is a comb-shaped electrode, 17 is a metal cap, and 18 is solder.

The surface acoustic wave device thus constituted is described in detail. The multi-layer substrate 1 is composed of, in this embodiment, dielectric layers 2, 3 made of low temperature baking material that can be baked below 1000°C. On the principal surface side of the dielectric layer 2 in a green sheet form having the via holes 9, 10, the input and output electrodes 4 and grounding electrode 5 are printed by electrode paste, and the grounding electrode 6 is printed by electrode paste to the principal surface side of the dielectric layer 3 of the green sheet form for forming a recess. From above, moreover, the dielectric layer 3 and dielectric layer 2 are laminated sequentially, and baked at 900°C. Consequently, by printing the outer electrode 7 by electrode paste, the outer terminal 8 is applied or printed and baked by electrode paste, and nickel/gold plating is applied. In this way, the outer electrode 7 is electrically connected to the input and output electrodes 4 through the via hole 9, to the grounding electrode 5 through the via hole 10, and to the grounding electrode 6 through the outer terminal 8. In this embodiment, moreover, an electrode paste of Ag derivative is used as the electrode paste of the input and output electrodes 4, grounding electrodes 5, 6, outer electrode 7, and outer terminal 8.

On the other hand, the surface acoustic wave element 14 in this embodiment is made of 36° Y-X lithium tantalate, and by the conventional photolithographic technique, the electrode pad 15 and comb-shaped electrode 16 made of metal mainly composed of aluminum are formed on one principal surface side of the piezoelectric substrate, thereby forming a surface acoustic wave filter. Next, the metal bump 11 is formed on the electrode pad 15 of the surface acoustic wave element 14 by using a gold wire, and the formed metal bump is adjusted to a uniform height, and the conductive resin 12 is transferred to the front end of the metal bump 11. In this embodiment, as the conductive resin 12, a thermoplastic conductive resin containing Ag-Pd alloy particles is used.

By positioning the input and output electrodes 4 and grounding electrode 5 of the multi-layer substrate 1, and the metal bump 11 formed on the surface acoustic wave element 14, the conductive resin 12 is cured to connect electrically and mechanically. Moreover, the thermosetting insulating resin 13 adjusted to a high viscosity is injected around the surface acoustic wave element 14 from between the surface acoustic wave element 14 and multi-layer substrate 1, so that a space may be held around the comb-shaped electrode 16, and by curing the adhesion strength of the surface acoustic wave element 14 and multi-layer substrate 1 is reinforced. Besides, by adhering the metal cap 17 with the grounding electrode 6 and solder18, airtight sealing is maintained.

The surface acoustic wave device in the first embodiment thus constituted possesses a guard layer by the dielectric layer 3, and is capable of preventing spreading of the insulating resin 13. Moreover, since the height of the guard layer is lower than the height of the surface acoustic wave element 14, if the gap between the surface acoustic wave element 14 and the guard layer is narrow, the insulating resin 13 of high viscosity can be easily injected to the periphery of the metal bump 11, and the adhesion strength of the surface acoustic wave element 14 and multi-layer substrate 1 can be obtained, so that the surface acoustic wave device can be reduced in size, thereby obtaining an ultra-small surface acoustic wave device of 2.5 mm x 2.8 mm x 1.5 mm.

Incidentally, each one of the dielectric layers 2, 3 for composing the multi-layer substrate 1 may be also made of plural layers, respectively.

### (Embodiment 2)

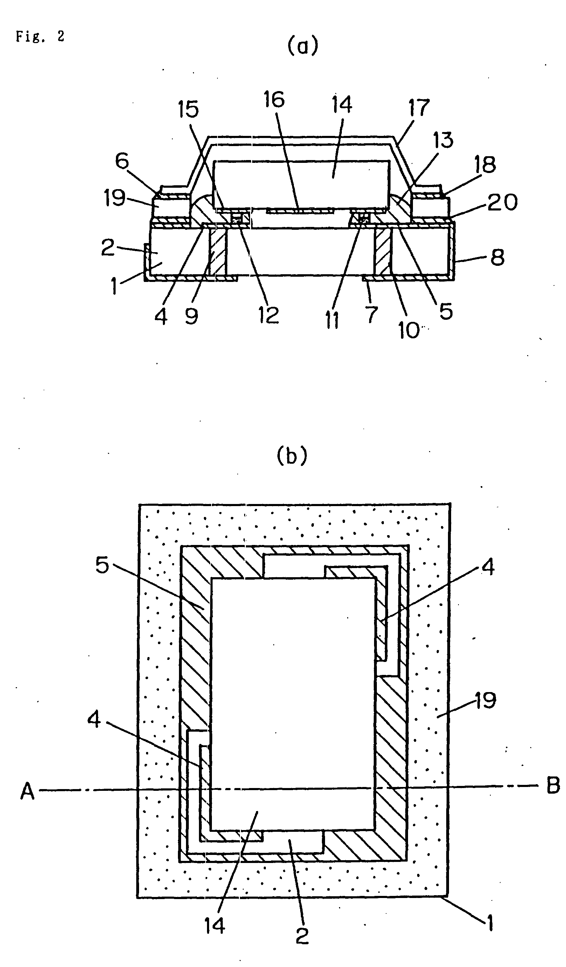

A second embodiment of the invention is described below by referring to the drawing. Fig. 2 (a) is a sectional view of a surface acoustic wave device in the second embodiment of the invention, and Fig. 2 (b) is its top view.

In the diagram, reference numeral 19 denotes a metal ring, 20 is a high temperature solder, and others same as in Fig. 1 (a) and (b) are identified with same reference numerals.

The surface acoustic wave device thus constituted is described below. The multi-layer substrate 1 is made of a dielectric layer 2, and input and output electrodes 4 and grounding electrode 5 are printed by electrode paste to the principal surface side of the dielectric layer 2 in a green sheet form having via holes 9 and 10. Consequently, baking at 900°C, the outer electrode 7 and outer terminal 8 are formed in the method shown in the first embodiment. Then, the metal ring 19 is adhered to the grounding electrode 5 with the high temperature solder 20, and a guard ring made of metal ring 19 is formed. On such multi-layer substrate 1, by mounting the surface acoustic wave element 14 in the method shown in the first embodiment, an ultra-small surface acoustic wave device can be obtained same as in the first embodiment.

The surface acoustic wave device in the second embodiment constitution in this way has the same action and effect as the surface acoustic wave device in the first embodiment.

Incidentally, the high temperature solder 20 may be only high in working temperature than the solder 18 for adhering the metal cap 17 and grounding electrode 6, and, for example, an Au/Sn alloy may be used. The dielectric layer 2 for composing the multi-layer substrate 1 may be also provided in plural layers.

### (Embodiment 3)

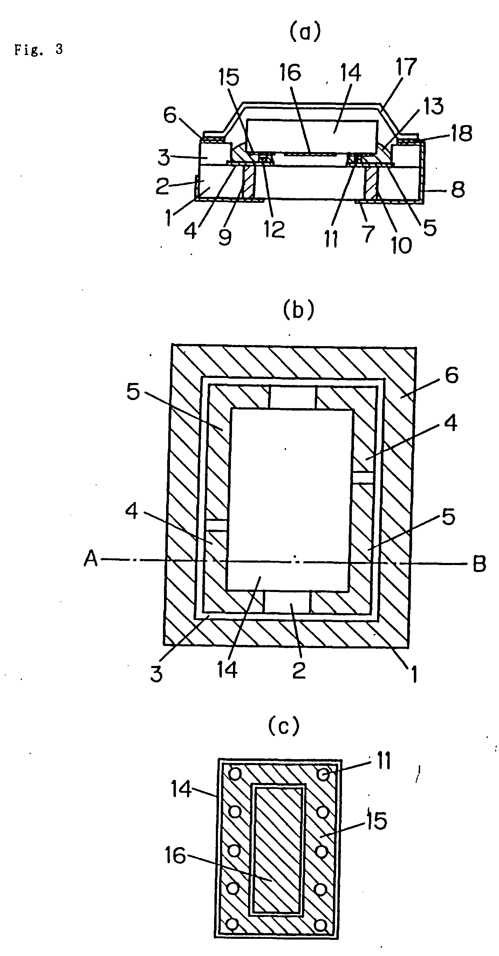

A third embodiment of the invention is described below while referring to the drawing. Fig. 3 (a) is a sectional view of a surface acoustic wave device in the third embodiment of the invention, Fig. 3 (b) is its top view, and Fig. 3 (c) is a top view of the functional surface of the surface acoustic wave element thereof.

In the diagram, those same as in Fig. 1 (a) and (b) are identified with same reference numerals.

The surface acoustic wave device thus constituted is described below. The metal bump 11 formed in the electrode pad 15 of the surface acoustic wave element 14 is formed only on two confronting sides as shown in Fig. 3 (c). The insulating resin 13 is injected only on two sides where the metal bump 11 is formed, and therefore the adhesion strength of the surface acoustic wave element 14 and multi-layer substrate 1 is reinforced. Besides, constitution of the multi-layer substrate 1 and mounting of the surface acoustic wave element 14 are same as in the method shown in the first embodiment, and an ultra-small surface acoustic wave device can be obtained. In this embodiment, the metal bump 11 is formed on two confronting sides in the longitudinal direction of the surface acoustic wave element 14.

In the surface acoustic wave device of the third embodiment thus constituted, since the metal bump 11 is disposed only on two confronting sides of the surface acoustic wave element 14, the insulating resin 13 for reinforcing the adhesion strength of the surface acoustic wave element 14 and multi-layer substrate 1 is also injected only in two sides on which the metal bump 11 is disposed. Hence, it is not necessary to keep a clearance between the multi-layer substrate 1 and the surface acoustic wave element 14 on two confronting sides in which the insulating resin 13 is not injected, so that the surface acoustic wave device of a smaller size than the'surface acoustic wave device shown in the first embodiment may be obtained. Besides, the same action and effect as in the surface acoustic wave device of the first embodiment are obtained.

If the insulating resin 13 is injected in two sides, there is no effect on the frequency characteristic and reliability of the surface acoustic wave device, and there is no problem. As the constitution of the multi-layer substrate 1, in this embodiment, the multi-layer substrate as shown in the first embodiment is used, but the multi-layer substrate as shown in the second embodiment may be also used.

### (Embodiment 4)

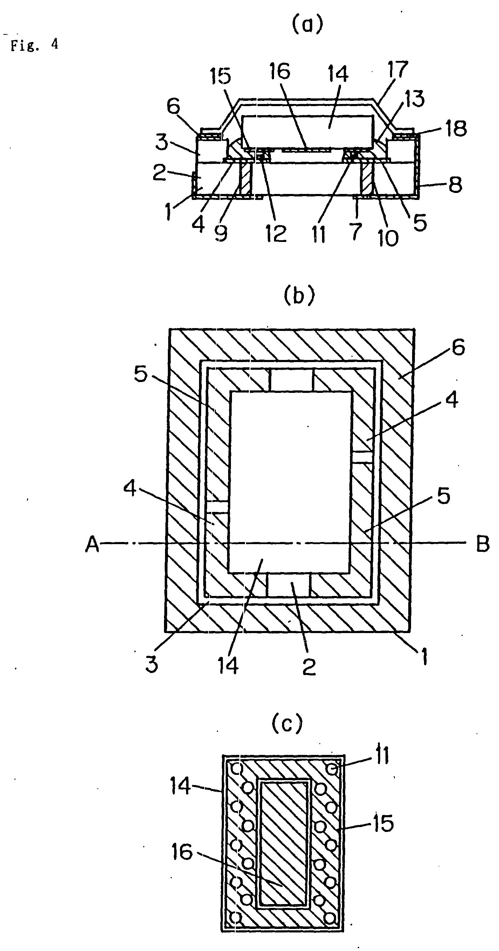

A fourth embodiment of the invention is described below while referring to the drawing. Fig. 4 (a) is a sectional view of a surface acoustic wave device in the fourth embodiment of the invention, Fig. 4 (b) is its top view, and Fig. 4 (c) is a top view of the functional surface of the surface acoustic wave element thereof.

In the diagram, those same as in Fig. 1 (a) and (b) are identified with same reference numerals.

The surface acoustic wave device thus constituted is described below. The metal bump 11 formed in the electrode pad 15 of the surface acoustic wave element 14 is formed only on two confronting sides as shown in Fig. 4 (c), and two rows are formed alternately each on one side. The insulating resin 13 is injected only on two sides where the metal bump 11 is formed, and therefore the adhesion strength of the surface acoustic wave element 14 and multi-layer substrate 1 is reinforced. Besides, constitution of the multi-layer substrate 1 and mounting of the surface acoustic wave element 14 are same as in the method shown in the first embodiment, and an ultra-small surface acoustic wave device can be obtained. In this embodiment, same as in the third embodiment, the metal bump 11 is formed on two confronting sides in the longitudinal direction of the surface acoustic wave element 14.

In the surface acoustic wave device of the fourth embodiment thus constituted, since the metal bump 11 is formed alternately in two rows each on each side of the metal bump 11, the insulating resin 13 hardly gets into the comb-shaped electrode 16 formed in the surface acoustic wave element 14, and it is easier to maintain the space around the comb-shaped electrode 16. Therefore, the degree of freedom of adjustment of viscosity of the insulating resin 13 having been adjusted to high viscosity is wide, and it is easier to adjust the viscosity. Besides, the same action and effect as in the surface acoustic wave device of the first and third embodiments are obtained.

Meanwhile, same as in the third embodiment, if the insulating resin 13 is injected in two sides, there is no effect on the frequency characteristic and reliability of the surface acoustic wave device, and there is no problem. As the constitution of the multi-layer substrate 1, in this embodiment, the multi-layer substrate as shown in the first embodiment is used, but the multi-layer substrate as shown in the second embodiment may be also used.

### (Embodiment 5)

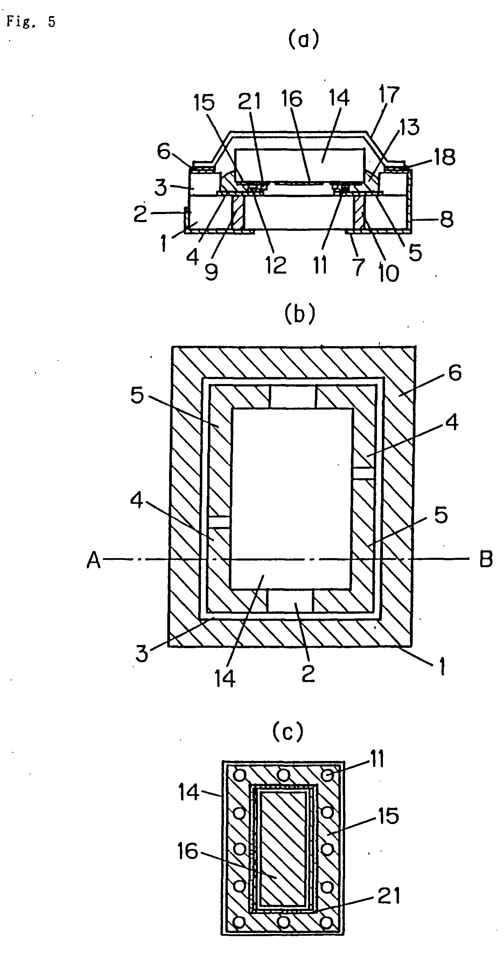

A fifth embodiment of the invention is described below while referring to the drawing. Fig. 5 (a) is a sectional view of a surface acoustic wave device in the fifth embodiment of the invention, Fig. 5 (b) is its top view, and Fig. 5 (c) is a top view of the functional surface of the surface acoustic wave element thereof.

In the diagram, reference numeral 21 is a second guard layer made of sound absorbing material, and others same as in Fig. 1 (a) and (b) are identified with same reference numerals.

The surface acoustic wave device thus constituted is described below. On the electrode pad 15 of the surface acoustic wave element 14, the sound absorbing material 21 is printed or applied, heated and cured, and the metal bump 11 is formed outside the second guard layer 21 made of sound absorbing material. Besides, by the constitution of the multi-layer substrate 1 and mounting of the surface acoustic wave element 14 same as in the method shown in the first embodiment, an ultra-small surface acoustic wave device can be obtained.

In the surface acoustic wave device of the fifth embodiment thus constituted, since the second guard layer 21 made of sound absorbing material is provided between the comb-shaped electrode 16 of the surface acoustic wave element 14 and metal bump 11, the insulating resin 13 hardly gets into the comb-shaped electrode 16 formed in the surface acoustic wave element 14, and it is easier to maintain the space around the comb-shaped electrode 16. Therefore, the degree of freedom of adjustment of viscosity of the insulating resin 13 having been adjusted to high viscosity is wide, and it is easier to adjust the viscosity. Besides, the same action and effect as in the surface acoustic wave device of the first embodiment are obtained.

Meanwhile, the second guard layer 21 made of sound absorbing material is provided on the whole circumference of the surface acoustic wave element 14. but when applied in the third and fourth embodiments, the second guard layer 21 made of sound absorbing material may be disposed only on two sides on which the metal bump 11 is disposed, so that the action and effect are same as in this embodiment. As the constitution of the multi-layer substrate 1, in this embodiment, the multi-layer substrate as shown in the first embodiment is used, but the multi-layer substrate as shown in the second embodiment may be also used.

### (Embodiment 6)

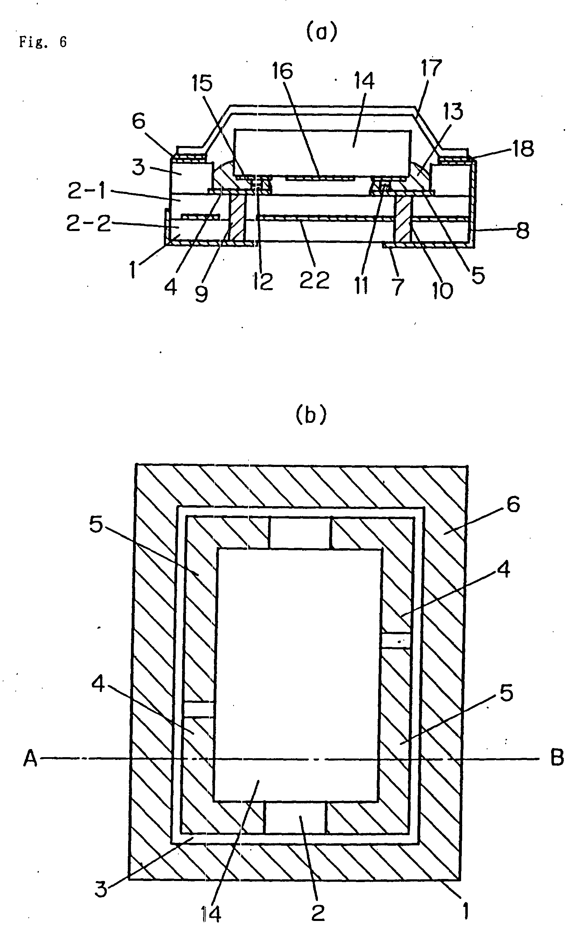

A sixth embodiment of the invention is described below by referring to the drawing. Fig. 6 (a) is a sectional view of a surface acoustic wave device in the sixth embodiment of the invention, and Fig. 6 (b) is its top view.

In the drawing, reference numeral 22 is a grounding electrode layer, and others same as in Fig. 1 (a) and (b) are identified with same reference numerals.

The surface acoustic wave device thus constituted is described below. The multi-layer substrate 1 in this embodiment is composed of dielectric layers 2, 3 made of low temperature baking material that can be baked at 1000°C or less, and the dielectric layer 2 is composed of plural layers 2-1 and 2-2. On the principal surface side of the dielectric layer 2-1 in green sheet form having via holes 9 and 10, input and output electrodes 4 and grounding electrode 5 are printed by electrode paste, on the principal surface side of the dielectric layer 2-2 in green sheet form having via holes 9 and 10, the grounding electrode layer 22 is printed by electrode paste, and on the principal surface side of the dielectric layer 3 in green sheet form having a recess, the grounding electrode 6 is printed by electrode paste. The dielectric layer 3, dielectric layer 2-1, and dielectric layer 2-2 are laminated sequentially from the top, and baked at 900°C. The outer electrode 7 and outer terminal 8 are formed in the method shown in the first embodiment. Thus, the outer electrode 7 is electrically connected with the input and output electrodes 4 through the via hole 9, with the grounding electrode 5 and grounding electrode layer 22 through the via hole 10, and with the grounding electrode 6 through the outer terminal 8. In the via hole 9, in the area intersecting with the grounding electrode layer 22, contacting with the grounding electrode layer 22 is avoided. By mounting the surface acoustic wave element 14 on such multi-layer substrate 1 by the method shown in the first embodiment, an ultra-small surface acoustic wave device as in the first embodiment can be obtained.

In the surface acoustic wave device of the sixth embodiment thus constituted, since the grounding electrode layer 22 is provided in the multi-layer substrate 1, external electromagnetic effects can be shut off, and a favorable frequency characteristic can be obtained. Besides, the same action and effect as in the surface acoustic wave device of the first embodiment are brought about.

In the embodiment, as the multi-layer substrate 1, the guard layer by the dielectric layer shown in the first embodiment is used, but the guard layer by metal ring shown in the second embodiment may be also used, or it may be also applied in the third, fourth and fifth embodiments.

### (Seventh embodiment)

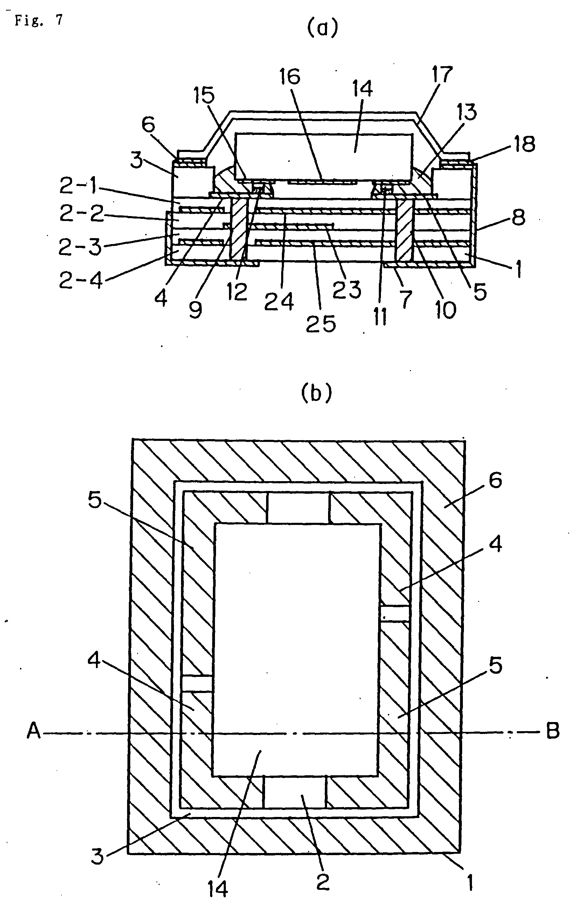

A seventh embodiment of the invention is described below by referring to the drawing. Fig. 7 (a) is a sectional view of a surface acoustic wave device in the seventh embodiment of the invention, and Fig. 7 (b) is its top view.

In the drawing, reference numeral 23 is a matching circuit unit and 24 and 25 are grounding electrode layers, and others same as in Fig. 1 (a) and (b) are identified with same reference numerals.

The surface acoustic wave device thus constituted is described below. The multi-layer substrate 1 in this embodiment is composed of dielectric layers 2, 3 made of low temperature baking material that can be baked at 1000°C or less, and the dielectric layer 2 is composed of plural layers 2-1, 2-2, 2-3, 2-4. On the principal surface side of the dielectric layer 2-1 in green sheet form having via holes 9 and 10, input and output electrodes 4 and grounding electrodes 5 are printed by electrode paste, on the principal surface side of the dielectric layers 2-2 and 2-4 in green sheet form having via holes 9 and 10, grounding electrode layers 24 and 25 are printed by electrode paste, on the principal surface side of the dielectric layer 2-3 in green sheet form having via holes 9 and 10, strip lines and capacitor electrode for composing the matching circuit unit 23 are printed by electrode paste, and on the principal surface side of the dielectric layer 3 in green sheet form for forming a recess, the grounding electrode 6 is printed by electrode paste. The dielectric layer 3, dielectric layer 2-1, dielectric layer 2-2, dielectric layer 2-3 and dielectric layer 2-4 are laminated sequentially from the top, and baked at 900°C. The outer electrode 7 and outer terminal 8 are formed by the method shown in the first embodiment. In this way, the outer electrode 7 is electrically connected with the input and output electrodes 4 through the via hole 9, with the grounding electrode 5 and grounding electrode layers 24 and 25 through the via hole 10, and with the grounding electrode 6 through the outer terminal 8, and the matching circuit unit 23 is electrically connected with the input and output electrodes 4 and outer electrode 7 through the via hole 9. In the via hole 9, in the area intersecting with the grounding electrode layers 24 and 25, contacting with the grounding electrode layers 24 and 25 is avoided. On such multi-layer substrate 1, by mounting the surface acoustic wave element 14 in the method shown in the first electrode, an ultra-small surface acoustic wave device same as in the first embodiment can be obtained.

In the surface acoustic wave device in the seventh embodiment thus stituted, two grounding electrode layers 24 and 25 are formed in different layers in the multi-layer substrate 1, and the matching circuit unit 23 is forme between them through the dielectric layer. Accordingly, if the input and output impedance of the surface acoustic wave element 14 differs from the impedance of the outer circuit, for example, by properly selecting the dimensions of the strip lines and the capacitor electrode of the matching circuit unit 23, for the surface acoustic wave filter for intermediate frequency band used in mobile communication appliance, the impedances can be matched, and therefore the size is reduced significantly as compared with the conventional matching circuit unit formed on the circuit substrate. Moreover, external electromagnetic effects can be shut off by the grounding electrode layers 24 and 25, and excellent frequency characteristics are obtained in both surface acoustic wave element and matching circuit unit. Besides, the same action and effect as in the surface acoustic wave device of the first embodiment are provided.

In the embodiment, as the multi-layer substrate, the guard layer by dielectric layer shown in the first embodiment is used, but the guard layer by metal ring shown in the second embodiment may be used, or it may be applied in the third, fourth and fifth embodiments.

Thus, in the first, second, third, fourth, fifth, sixth and seventh embodiments, lithium tantalate is used as the piezoelectric substrate of the surface acoustic wave element, but lithium niobate, lithium borate, or rock crystal may be used. As the metal bump, instead of gold used herein, aluminum may be also used. As the electrode paste used in the strip lines and capacitor electrodes for composing the input and output electrodes, grounding electrode, outer electrode, outer terminal, grounding electrode layer, and matching circuit unit, Ag compound electrode paste is used, but Cu compound electrode paste may be also used. The dielectric material for composing the multi-layer substrate, an low temperature baking material that can be baked at 1000°C may be used, and for example, materials of alumina glass compound may be used.

## Claims

1. A surface acoustic wave device comprising:
a multi-layer substrate (1) possessing input and output electrodes (4) and grounding electrode (5, 6) on the mounting surface side of a dielectric layer, and possessing an outer electrode (7) on the other surface of said dielectric layer, with said input and output electrodes and grounding electrode connected electrically with the outer electrode respectively,
a surface acoustic wave element (14) mounting a principal surface forming an electrode pad (15) and comb-shaped electrode (16) on said multi-layer substrate by face-down method,
a metal bump (11) applying a conductive resin (12), being formed on said electrode pad, and
an insulating resin (13) formed on the periphery of the metal bump,
wherein said input and output electrodes and grounding electrode of said dielectric layer are electrically connected with said surface acoustic wave element through said metal bump, and
a guard layer (3) shorter in height than the surface acoustic wave element is formed outside of the surface acoustic wave element, on the mounting surface side of said multi-layer substrate.

2. A surface acoustic wave device of claim 1, wherein the piezoelectric substrate for composing the surface acoustic wave element is at least one selected from the group consisting of lithium tantalate, lithium niobate, lithium borate, and rock crystal.

3. A surface acoustic wave device of claim 1, wherein the metal bump is made of gold or aluminum.

4. A surface acoustic wave device of claim 1, wherein the guard layer is made of the same dielectric material as the dielectric layer for composing the multi-layer substrate.

5. A surface acoustic wave device of claim 1 or 4, wherein the material of the dielectric for composing the multi-layer substrate is a low temperature baking material that can be baked at 1000°C or less, and the conductors for composing the input and output electrodes, grounding electrode, and outer electrode are made of silver compound or copper compound.

6. A surface acoustic wave device of claim 1, wherein the guard layer is made of a metal ring, and the guard layer is electrically connected with the grounding electrode, and not electrically connected with the input and output electrodes.

7. A surface acoustic wave device of claim 1, wherein the metal bump is disposed on two confronting sides of the principal surface of the surface acoustic wave element.

8. A surface acoustic wave device of claim 7, wherein the metal bumps disposed on two confronting sides of the principal surface of the surface acoustic wave element are disposed alternately by two rows each on each side.

9. A surface acoustic wave device of claim 1, wherein a second guard layer is formed on the principal surface of the surface acoustic wave element so as to be positioned between the metal bump and comb-shaped electrode.

10. A surface acoustic wave device of claim 9, wherein the second guard layer formed on the principal surface of the surface acoustic wave element is made of a sound absorbing material.

11. A surface acoustic wave device of claim 1, wherein the multi-layer substrate mounting the surface acoustic wave element is formed in plural layers, at least one grounding electrode layer is interposed in the plural-layer substrate, and the grounding electrode formed on the upper principal surface of the multi-layer substrate is electrically connected with said grounding electrode layer.

12. A surface acoustic wave device of claim 1, wherein the multi-layer substrate mounting the surface acoustic wave element is formed in a laminate structure of at least four layers, grounding electrode layers are formed on the principal surface side of the second layer and fourth layer from the top, a matching circuit unit composed of strip lines and capacitor electrode is formed on the principal surface side of the third layer from the top, and this matching circuit unit is electrically connected with the input and output electrodes formed on the principal surface of the first layer.

## Patentansprüche

1. Akustische Oberflächenwellenvorrichtung, die umfasst:
ein mehrschichtiges Substrat (1), das Eingangs- und Ausgangselektroden (4) sowie eine Erdungselektrode (5,6) auf der Montageflächenseite einer dielektrischen Schicht aufweist und eine Außenelektrode (7) an der anderen Fläche der dielektrischen Schicht aufweist, wobei die Eingangs- und Ausgangselektroden sowie die Erdungselektrode jeweils elektrisch mit der Außenelektrode verbunden sind,
ein akustisches Oberflächenwellenelement (14), dessen Hauptfläche, die eine Elektrodenkontaktstelle (15) und eine kammförmige Elektrode (16) aufweist, durch ein Face-down-Verfahren auf dem mehrschichtigen Substrat montiert wird,
einen Metall-Bondhügel (11), durch den ein leitendes Harz (12) aufgetragen wird, das auf der Elektrodenkontaktstelle ausgebildet ist, und
ein isolierendes Harz (13), das am Umfang des Metall-Bondhügels ausgebildet ist,
wobei die Eingangs- und Ausgangselektroden sowie die Erdungselektrode der dielektrischen Schicht über den Metall-Bondhügel elektrisch mit dem akustischen Oberflächenwellenelement verbunden sind, und
eine Schutzschicht (3), deren Höhe geringer ist als die des akustischen Oberflächenwellenelementes, die außerhalb des akustischen Oberflächenwellenelementes auf der Montageflächeseite des mehrschichtigen Substrats ausgebildet ist.

2. Akustische Oberflächenwellenvorrichtung nach Anspruch 1, wobei das piezoelektrische Substrat, das das akustische Oberflächenwellenelement bildet, wenigstens eines ist, das aus der Gruppe ausgewählt wird, die aus Lithiumtantalat, Lithiumniobat, Lithiumborat und Bergkristall besteht.

3. Akustische Oberflächenwellenvorrichtung nach Anspruch 1, wobei der Metall-Bondhügel aus Gold oder Aluminium besteht.

4. Akustische Oberflächenwellenvorrichtung nach Anspruch 1, wobei die Schutzschicht aus dem gleichen dielektrischen Material besteht wie die dielektrische Schicht zur Bildung des mehrschichtigen Substrats.

5. Akustische Oberflächenwellenvorrichtung nach Anspruch 1 oder 4, wobei das Material des Dielektrikums zur Bildung des mehrschichtigen Substrats ein Niedrigtemperatur-Brennmaterial ist, das bei 1000°C oder weniger gebrannt werden kann, und die Leiter zur Bildung der Eingangs- und Ausgangselektroden, der Erdungselektrode sowie der Außenelektroden aus Silberverbindung oder Kupferverbindung bestehen.

6. Akustische Oberflächenwellenvorrichtung nach Anspruch 1, wobei die Schutzschicht aus einem Metallring besteht und die Schutzschicht elektrisch mit der Erdungselektrode verbunden ist und nicht elektrisch mit den Eingangs- und Ausgangselektroden verbunden ist.

7. Akustische Oberflächenwellenvorrichtung nach Anspruch 1, wobei der Metall-Bondhügel an zwei einander gegenüberliegenden Seiten der Hauptfläche des akustischen Oberflächenwellenelementes angeordnet ist.

8. Akustische Oberflächenwellenvorrichtung nach Anspruch 7, wobei die Metall-Bondhügel, die auf zwei einander gegenüberliegenden Seiten der Hauptfläche des akustischen Oberflächenwellenelementes angeordnet sind, abwechselnd durch zwei Reihen auf jeder Seite gebildet werden.

9. Akustische Oberflächenwellenvorrichtung nach Anspruch 1, wobei eine zweite Schutzschicht auf der Hauptfläche des akustischen Oberflächenwellenelementes so ausgebildet ist, dass sie sich zwischen dem Metall-Bondhügel und der kammförmigen Elektrode befindet.

10. Akustische Oberflächenwellenvorrichtung nach Anspruch 9, wobei die zweite Schutzschicht, die auf der Hauptfläche des akustischen Oberflächenwellenelementes ausgebildet ist, aus einem schalldämpfenden Material besteht.

11. Akustische Oberflächenwellenvorrichtung nach Anspruch 1, wobei das mehrschichtige Substrat, an dem das akustische Oberflächenwellenelement montiert ist, in mehreren Schichten ausgebildet ist, wobei wenigstens eine Erdungselektrodenschicht in dem mehrschichtigen Substrat angeordnet ist, und die Erdungselektrode, die auf der oberen Hauptfläche des mehrschichtigen Substrats ausgebildet ist, elektrisch mit der Erdungselektrodenschicht verbunden ist.

12. Akustische Oberflächenwellenvorrichtung nach Anspruch 1, wobei das mehrschichtige Substrat, an dem das akustische Oberflächenwellenelement montiert ist, in einer Laminatstruktur aus wenigstens vier Schichten ausgebildet ist und wobei Erdungselektrodenschichten auf der Hauptflächenseite der zweiten Schicht und der vierten Schicht von der Oberseite her ausgebildet sind, eine Anpassungsschaltungseinheit, die aus Streifenleitern und einer Kondensatorelektrode besteht, auf der Hauptflächenseite der dritten Schicht von der Oberseite her ausgebildet ist, und diese Anpassungsschaltungseinheit elektrisch mit den Eingangs- und Ausgangselektroden verbunden ist, die auf der Hauptfläche der ersten Schicht ausgebildet sind.

## Revendications

1. Dispositif à ondes acoustiques de surface, comprenant :
un substrat multicouche (1) comportant des électrodes d'entrée et de sortie (4) et une électrode de mise à la masse (5, 6) sur le côté surface de montage d'une couche diélectrique, et comportant une électrode extérieure (7), située sur l'autre surface de ladite couche diélectrique, lesdites électrodes d'entrée et de sortie et ladite électrode de mise à la masse étant électriquement reliée, respectivement, à l'électrode extérieure ;
un élément à ondes acoustiques de surface (14), montant une surface principale formant une plage de connexion d'électrode (15) et une électrode en forme de peigne (16) sur ledit substrat multicouche, par le procédé de montage avec la face en dessous ;
une bosse métallique (11), sur laquelle est appliquée une résine conductrice (12), étant formée sur ladite plage de connexion d'électrode ; et
une résine isolante (13), formée sur la périphérie de la bosse métallique ;
dans lequel lesdites électrodes d'entrée et de sortie et l'électrode de mise à la masse de ladite couche diélectrique sont électriquement reliées audit élément à ondes acoustiques de surface, par l'intermédiaire de ladite bosse métallique ; et
une couche de garde (3), de plus petite hauteur que l'élément à ondes acoustiques de surface, est formée à l'extérieur de l'élément à ondes acoustiques de surface, sur le côté surface de montage dudit substrat multicouche.

2. Dispositif à ondes acoustiques de surface selon la revendication 1, dans lequel le substrat piézoélectrique, servant à constituer l'élément à ondes acoustiques de surface, est au moins une matière sélectionnée à partir du groupe composé par le tantalate de lithium, le niobate de lithium, le borate de lithium et le cristal de roche.

3. Dispositif à ondes acoustiques de surface selon la revendication 1, dans lequel la bosse métallique est faite en or ou en aluminium.

4. Dispositif à ondes acoustiques de surface selon la revendication 1, dans lequel la couche de garde est faite à partir du même corps diélectrique que la couche diélectrique servant à composer le substrat multicouche.

5. Dispositif à ondes acoustiques de surface selon la revendication 1 ou 4, dans lequel le corps utilisé pour le diélectrique servant à composer le substrat multicouche est une matière à cuisson à basse température, qui peut être cuite à 1 000 °C ou moins, et dans lequel les conducteurs, servant à composer les électrodes d'entrée et de sortie, l'électrode de mise à la masse et l'électrode extérieure, sont faits en un composé à l'argent ou en un composé au cuivre.

6. Dispositif à ondes acoustiques de surface selon la revendication 1, dans lequel la couche de garde est faite d'un anneau métallique, et dans lequel la couche de garde est électriquement reliée à l'électrode de mise à la masse mais n'est pas électriquement reliée aux électrodes d'entrée et de sortie.

7. Dispositif à ondes acoustiques de surface selon la revendication 1, dans lequel la bosse métallique est disposée sur deux côtés se faisant face sur la surface principale de l'élément à ondes acoustiques de surface.

8. Dispositif à ondes acoustiques de surface selon la revendication 7, dans lequel les bosses métalliques, disposées sur deux côtés se faisant face sur la surface principale de l'élément à ondes acoustiques de surface, sont placées en alternance en deux rangées chacune de chaque côté.

9. Dispositif à ondes acoustiques de surface selon la revendication 1, dans lequel une seconde couche de garde est formée sur la surface principale de l'élément à ondes acoustiques de surface, de manière à être placée entre la bosse métallique et l'électrode en forme de peigne.

10. Dispositif à ondes acoustiques de surface selon la revendication 9, dans lequel la seconde couche de garde, formée sur la surface principale de l'élément à ondes acoustiques de surface, est faite en une matière absorbant les ondes sonores.

11. Dispositif à ondes acoustiques de surface selon la revendication 1, dans lequel le substrat multicouche, sur lequel est monté l'élément à ondes acoustiques de surface, est constitué par une pluralité de couches, au moins une couche formant électrode de mise à la masse étant intercalée dans le substrat à plusieurs couches, et dans lequel l'électrode de mise à la masse, formée sur la surface principale supérieure du substrat multicouche, est électriquement reliée à ladite couche formant électrode de mise à la masse.

12. Dispositif à ondes acoustiques de surface selon la revendication 1, dans lequel le substrat multicouche, sur lequel est monté l'élément à ondes acoustiques de surface, est constitué par une structure stratifiée d'au moins quatre couches, les couches formant électrodes de mise à la masse étant formées sur le côté surface principale de la deuxième et de la quatrième couches à partir du haut, une unité formant circuit d'adaptation, composée de lignes à rubans et d'une électrode de condensateur, étant formée sur le côté surface principale de la troisième couche à partir du haut, et cette unité formant circuit d'adaptation étant électriquement reliée aux électrodes d'entrée et de sortie, formées sur la surface principale de la première couche.
